# EUROPEAN PATENT SPECIFICATION

(11) **EP 4 139 965 B1**
(45) Date of publication and mention of the grant of the patent: **09.12.2026**
(21) Application number: 21719528.8
(22) Date of filing: 31.03.2021
(51) Int. Cl.: H10D 12/00, H10D 12/01, H10D 62/10, H10D 64/00

(54) **POWER SEMICONDUCTOR DEVICE**
LEISTUNGSHALBLEITERANORDNUNG
DISPOSITIF À SEMI-CONDUCTEUR DE PUISSANCE

(43) Date of publication of application: 01.03.2023
(73) Proprietor: Dynex Semiconductor Limited, Lincoln, Lincolnshire LN6 3LF (GB); Zhuzhou CRRC Times Semiconductor Co., Ltd., Zhuzhou, Hunan 412001 (CN)
(72) Inventor: ZHU, Chunlin, Lincoln, Lincolnshire LN4 2UA (GB); LIU, Guoyou, Zhuzhou, Hunan 412001 (CN)
(74) Representative: Iqbal, Md Mash-Hud
(86) International application number: PCT/CN2021/084443
(87) International publication number: WO 2022/205081

(56) References cited:
- US-A1- 2005 263 852
- US-A1- 2017 278 956
- US-A1- 2018 019 160

## Description

### Technical Field

The present disclosure relates to a power semiconductor device. More particularly, but not exclusively, the present disclosure relates to a trench-gate power semiconductor device with an insulation trench.

### Background

Power semiconductor devices (such as, insulated-gate bipolar transistors (IGBTs)) have been widely used as power switches in a variety of power applications. Important operating parameters of IGBTs typically include the on-state voltage drop between the collector and the emitter (V_{CE,sac}), the switching loss (E_{SW}), and the safe operating area (SOA). V_{CE,sat} and E_{SW} indicate the efficiency of an IGBT while SOA indicates the reliability of an IGBT.

Generally speaking, there are two common types of IGBT structures. One type is called a planar-gate IGBT in which a gate electrode is provided on a surface of a wafer. The other type is called a trench-gate IGBT in which a trench structure is formed in a wafer and a gate electrode is buried in the trench structure. The trench-gate IGBT has a MOS channel which is vertical to the wafer surface, and the vertical MOS channel effectively eliminates a JFET effect in the planar gate structure. Concurrently, as the MOS channel density is not limited by the chip surface area, the channel density can be improved greatly. In this way, as compared to the planar-gate IGBT, the trench-gate IGBT can provide an increased channel density and accordingly a reduced on-state voltage drop V_{CE,sat}. However, the trench-gate IGBT has a worse short-circuit current capability or a poorer short-circuit SOA (SCSOA) due to its high saturation collector current density. Therefore, in the latest trench gate technology, dummy regions have been adopted to optimize the trade-off performance between *V_{CE,sat}* and SCSOA without sacrificing the reverse blocking voltage.

The dummy regions (which include dummy trenches as well as dummy wells between the dummy trenches) introduce additional parasitic capacitance and more space to store free electron-hole carriers which need to be removed or flood in when the device is turned off or turned on. It has been reported that the dummy trenches could be electrically connected to the active gate electrodes of the trench-gate IGBT, but this type of connections would result in large switching loss due to increased gate-collector capacitance (C_{GC}). It is also known that the dummy trenches may be electrically connected to the emitter electrode of the IGBT, but this type of connections would increase the turn-on switching speed (represented by the rate of change of the collector current, di/dt) and may result in uncontrollable di/dt through changing a gate resistor R_{g,on}.

Therefore, it is often required to trade off one operating parameter of an IGBT for the improvement of another operating parameter of the IGBT. Similar problems exist for other types of power semiconductor devices.

It is generally desirable to provide a power semiconductor device which has an improved device efficiency as well as an improved reliability.

US2018/019160 A1 describes a semiconductor device and a manufacturing method that aim to prevent the breakage of an element and in which the control of impurity amounts is less susceptible to variations in manufacturing processes. According to US2018/019160 A1 active cells are arranged in stripes. Rectangular holes filled with an insulating material are positioned between the active cells.

US2017/278956 A1 describes a semiconductor device having an IGBT. The semiconductor device includes an embedded insulating film formed on the surface side of the semiconductor substrate between the first IGBT cell region and the second IGBT cell region.

US2005/263852 A1 describes a semiconductor device including a gate electrode formed within a trench, and isolated from the second base layers and the emitter layer by an insulating film. A space section is provided between the second base layers adjacent to each other, the space section being deeper than the second base layers and being electrically isolated from the emitter layer and the second base layers.

### Summary

The invention is defined by the independent claims. Embodiments are described by the dependent claims.

It is an object of the present disclosure, among others, to provide an improved power semiconductor device which solves the problems associated with known structures, whether identified herein or otherwise.

According to a first aspect of the present disclosure, there is provided a power semiconductor device, as defined in claim 1.

According to the invention, an active cell has a first length L1 along a second direction perpendicular to the first direction, and the insulation trench has a second length L2 along the second direction, and the first and second lengths L1 and L2 satisfy the relationship of 0.5≤L2/L1≤2.

As compared to prior designs of power semiconductor devices (e.g., IGBTs) which provide a dummy semiconductor region to neighbour an active cell, using the insulation trench of the first aspect to replace at least a part of the dummy semiconductor region is advantageous for improving the SOA and the switching controllability, and reducing the switching loss and the EMI noise of the power semiconductor device, while providing a similar level of current density. The length L1 of the active cell and the length L2 of the insulation trench follow the design rule of 0.5 ≤ L2/L1 ≤ 2, which is useful for keeping uniform electric field distribution on the chip front side (thereby improving the reliability of the device) and for maintaining process uniformity and controllability. L2/L1 refers to a ratio of the second length L2 and the first length L1.

Preferably, the first and second lengths L1 and L2 may further satisfy the relationship of L2/L1 ≤ 1.7. More preferably, the first and second lengths L1 and L2 may further satisfy the relationship of L2/L1 ≤ 1.5. By making L2/L1 not greater than 2, preferably not greater than 1.7, and most preferably not greater than 1.5, the electric field under the insulation trench may be prevented from reaching an excessive level when the device is reversely biased, thereby protecting the device from breaking down.

Preferably, the first and second lengths L1 and L2 may further satisfy the relationship of L2/L1 ≥ 1. By making L2/L1 not lower than 0.5, more preferably not lower than 1, the risk of the device suffering from a high short circuit current is reduced, thereby allowing the device to have an acceptance SCSOA performance.

The emitter region may be selectively provided at the first side of the semiconductor substrate.

The active cell may further comprise a first implant zone provided between the active base region and the drift layer, wherein the first implant zone is of the second conductivity type and has a higher doping concentration than the drift layer.

Advantageously, the first implant zone improves the conductivity modulation in the power semiconductor device by enhancing the carrier profile in the drift layer during the on state, thereby reducing V_{CE,sac} of the power semiconductor device.

The active gate trench may be configured to extend through the base layer and the first implant zone into the drift layer.

The insulation trench may be filled exclusively with the dielectric material.

In other words, the insulation trench is not filled with any semiconducting or electrically conducting material. The dielectric material may comprise more than one type of dielectric material.

The insulation trench may be configured to extend from the surface of the semiconductor substrate at the first side into the drift layer.

The insulation trench and the active gate trench may have substantially the same depth along the first direction.

The power semiconductor device may further comprise an emitter electrode which is electrically connected to the emitter region of the active cell and a collector electrode which is electrically connected to collector layer.

The active cell may further comprise a second implant zone between the active gate trench and the drift layer, the second implant zone having the first conductivity type.

Advantageously, the second implant zone shields the bottom of the active gate trench from the bombing holes injected by the collector layer during an on state of the power semiconductor device, and accordingly, protects the active gate trench from trapping holes bombing from the collector layer. As a result, the second implant zone improves the reliability of the power semiconductor device. Further, the second implant zone provides better blocking capability for the power semiconductor device.

The second implant zone between the active gate trench and the drift layer may be of a floating potential, i.e., not electrically connected to any electrode of the power semiconductor device.

The second implant zone may also be provided between the insulation trench and the drift layer.

Advantageously, the second implant zone between the insulation trench and the drift layer provides better blocking capability for the power semiconductor device.

The second implant zone between the insulation trench and the drift layer may be electrically connected to the emitter electrode.

The second direction may be parallel to the surface of the semiconductor substrate. The active cell may be configured to provide at least one current channel during an on-state of the power semiconductor device. It would be appreciated that the active cell refers to a minimum repeating unit that is able to conduct current in a whole power semiconductor device.

The active cell may further comprise a dummy base region which is a part of the base layer, and wherein the active base region and the dummy base region are provided at opposite sides of the active gate trench, such that the active cell provides a single current channel during the on-state of the power semiconductor device.

It would be appreciated that the single current channel is provided by the active base region during the on-state of the power semiconductor device, and that the dummy base region does not have any emitter region therein.

The first implant zone may also be provided between the dummy base region and the drift layer.

The dummy base region of the active cell may be of a floating potential or may be electrically connected to the emitter electrode.

The active cell may be configured to provide two current channels located at opposite sides of the active gate trench during the on-state of the power semiconductor device. The active gate trench may be provided in the middle of the active cell along the second direction.

The power semiconductor device comprises a plurality of the active cells and a plurality of the insulation trenches.

The active cells and the insulation trenches are arranged along the second direction. Each active cell may be provided immediately between two of the insulation trenches along the second direction

According to an example not forming part of the invention but being useful for its understanding, a single one of the insulation trenches may be provided immediately between neighbouring ones of the active cells.

The expression "immediately between" means that there is no other structure between neighbouring ones of the active cells. In other words, the distance between the neighbouring ones of the active cells along the second direction is the second length L2 of the insulation trench.

The power semiconductor device further comprises a dummy cell. The dummy cell comprises a dummy base region which is a part of the base layer.

It would be appreciated that the dummy cell does not provide any current channel during an on-state of the power semiconductor device.

The dummy cell may further comprise a dummy gate trench which comprises a gate insulator and a dummy gate electrode disposed therein.

The dummy gate electrode and the dummy base region of the dummy cell may be electrically connected to the emitter electrode. Alternatively, the dummy gate electrode may be electrically connected to the active gate electrode.

The active gate electrode and the dummy gate electrode may be made of polysilicon. A length of the dummy cell along the second direction is equal to the first length L1.

The dummy gate trench may have the same dimension as the active gate trench.

The dummy gate trench may be provided in the middle of the dummy cell along the second direction.

The first implant zone may also be provided within the dummy cell between the dummy base region and the drift layer.

The second implant zone may also be provided within the dummy cell between the dummy gate trench and the drift layer.

The power semiconductor device comprises a plurality of the dummy cells. At least one of the dummy cells and at least two of the insulation trenches are provided between neighbouring ones of the active cells along the second direction. The insulation trenches are provided between a dummy cell and an active cell along the second direction.

The power semiconductor device may further comprise a buffer layer having the second conductivity type, wherein the buffer layer is provided between the drift layer and the collector layer, and has a higher doping concentration than the drift layer. Advantageously, the buffer layer is useful for reducing the on-state voltage drop V_{CE,sat} of the power semiconductor device.

The power semiconductor device may comprise an insulated-gate bipolar transistor (IGBT).

According to a second aspect of the present disclosure, there is provided a method of manufacturing a power semiconductor device according to claim 14.

Where appropriate any of the optional features described above in relation to the first aspect of the present disclosure may be applied to the second aspect of the disclosure.

### Brief Description of the Drawings

In order that the disclosure may be more fully understood, a number of embodiments of the present disclosure will now be described, by way of example, with reference to the accompanying drawings, in which:
Figure 1 is a schematic representation of a cross sectional view of a power semiconductor device according to a first embodiment of the present disclosure; said first embodiment does not form part of the claimed invention but it is useful for its understanding;
Figure 2 is a schematic representation of a cross sectional view of a power semiconductor device according to a second embodiment of the present disclosure; said second embodiment does not form part of the claimed invention but it is useful for its understanding;
Figure 3 is a schematic representation of a cross sectional view of a power semiconductor device according to a third embodiment of the present disclosure;
Figure 4 is a schematic representation of a cross sectional view of a power semiconductor device according to a fourth embodiment of the present disclosure;
Figure 5 is a schematic representation of a cross sectional view of a power semiconductor device according to a fifth embodiment of the present disclosure;
Figures 6-1 to 6-9 illustrate a method for manufacturing a power semiconductor device according to the fourth embodiment.

In the figures, like parts are denoted by like reference numerals.

It will be appreciated that the drawings are for illustration purposes only and are not drawn to scale.

### Detailed Description of the Preferred Embodiments

Hereafter, referring to the attached drawings, a detailed description will be given of preferred embodiments of a power semiconductor device according to the disclosure. A layer or region being prefixed by N or P in the description and attached drawings means that electrons or holes respectively are majority carriers. Also, '+' or '-' added to N or P indicates a higher impurity concentration or lower impurity concentration respectively than in a layer or region to which '+' or '-' is not added. Doping regions of the same relative doping concentration do not necessarily have the same absolute doping concentration. For example, two different 'N' doping regions may have the same or different absolute doping concentrations. In the following descriptions and attached drawings, the same reference signs are given to the same configurations, and redundant descriptions are omitted.

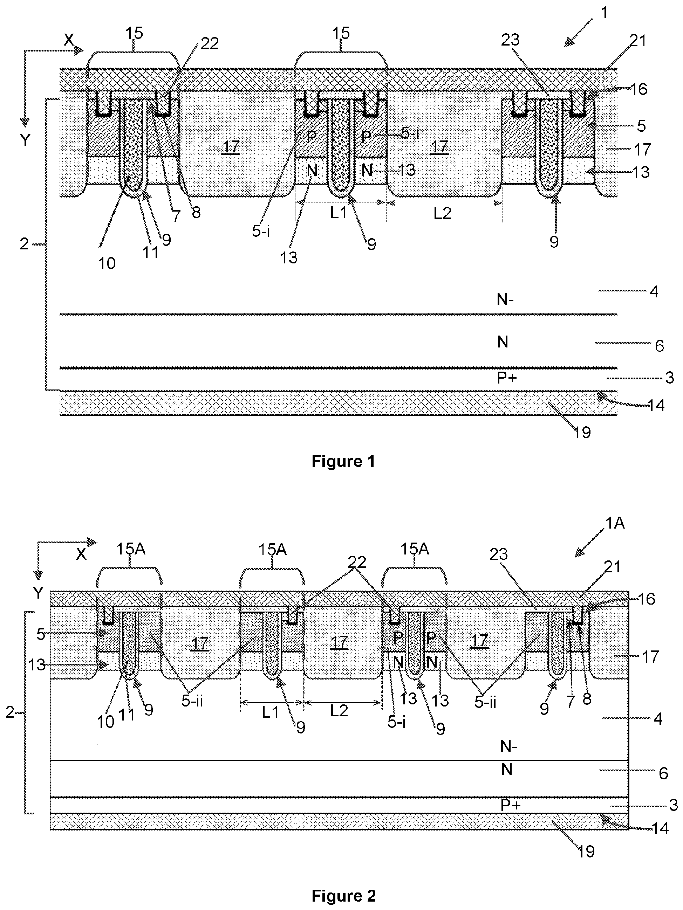

Figure 1 schematically illustrates a cross-sectional view of a power semiconductor device 1 according to a first embodiment of the present disclosure. The first embodiment does not form part of the claimed invention but it is useful for its understanding. In the example provided by Figure 1, the power semiconductor device is embodied as a trench-gate IGBT. The IGBT 1 is formed on a semiconductor substrate 2. The semiconductor substrate 2 comprises a P type base layer 5 provided at a first side of the substrate, a P+ type collector layer 3 provided at a second opposite side of the substrate, a N- type drift layer 4 between the collector layer 3 and the base layer 5, and a N type buffer layer 6 between the P+ type collector layer 3 and the N- type drift layer 4. The semiconductor substrate 2 has a first surface 16 at the first side (e.g., the top surface as shown in Figure 1) and a second surface 14 at the second side (e.g., the bottom surface). The second surface 14 is a surface of the P+ type collector layer 3. The first surface 16 is a surface of the P type base layer 5.

A plurality of active cells 15 and a plurality of insulation trenches 17 are formed within the semiconductor substrate 2. As shown in Figure 1, the active cells 15 and the insulation trenches 17 are arranged in an alternating manner along an X axis. In other words, an insulation trench 17 is provided immediately between two adjacent active cells 15. There is no other structure between neighbouring ones of the active cells. The X axis is generally parallel to the first surface 16 or the second surface 14 of the substrate 2. While Figure 1 shows that the IGBT 1 has three active cells, it would be understood that this is just for simplifying the illustration, and that in reality, an IGBT may typically have hundreds to thousands of active cells.

The active cells 15 are designed to have identical dimensions and configurations. With the expression "active cell", it is meant that the cell would provide at least one current channel during an on-state of the IGBT 1. Each active cell 15 comprises an active gate trench 9. Each active gate trench 9 comprises a gate insulator 11 which for example may be a thin layer of oxide film, and an active gate electrode 10 which for example may be made of polysilicon. The expressions "active gate electrode" and "active gate trench" mean that the gate electrode within the gate trench is a control electrode, which controls the on/off of the current channel(s) of the active cell 15. Each active gate trench 9 is in a stripe form extending from the first surface 16 through the P type base layer 5 into the N- drift layer 4. The extending direction of the active gate trenches 9 is along a Y axis. The Y axis is generally perpendicular to the X axis. The active gate trenches 9 of the plurality of active cells 15 are aligned in the X axis. The Y axis may also be referred to as the "first direction" or the depth direction of the substrate 2, and the X axis may also be referred to as the "second direction" or the lateral direction of the substrate 2.

The base layer 5 is divided by the insulation trenches 17 and the active gate trenches 9 into a plurality of P type active base regions 5-i. Each active cell 15 further comprises two of the P type active base regions 5-i which are located at opposite sides of the respective active gate trench 9. The P type active base regions 5-i may also be referred to as active P wells.

As further shown in Figure 1, there is a first implant zone 13 between each active base region 5-i and the N- drift layer 4. The first implant zone 13 is N type. As its name suggests, the first implant zone 13 was formed by implantation. Therefore, all of the first implant zones 13 may be formed in the substrate 2 simultaneously.

Each active cell 15 further comprises an N+ type emitter region 7 which is selectively provided within a respective active base region 5-i adjacent to the first surface 16 of the substrate 2. In the example of Figure 1, each active cell 15 is able to provide two current channels along the two sidewalls of the active gate trench 9 during an on state of the IGBT 1.

Each of the insulation trenches 17 is filled with a dielectric material. The dielectric material may also be referred to as an electrically insulating material. An example of the dielectric material is silicon dioxide. Preferably, each of the insulation trenches 17 is filled exclusively with a dielectric material, i.e., not filled with any semiconducting or electrically conducting material. The dielectric material within each insulation trench 17 may comprise more than one type of dielectric material. The insulation trenches 17 also extend from the first surface 16 through the P type base layer 5 into the N- drift layer 4. The extending direction of the insulation trenches 17 is along a Y axis. The insulation trenches 17 have substantially the same depth as the active gate trenches 9 along the Y axis.

The IGBT 1 further comprises a collector electrode 19 which is electrically connected to the P+ type collector layer 3, an emitter electrode 21 which is electrically connected to each emitter region 7. The emitter electrode 21 may include a barrier layer made of titanium nitride, tantalum nitride, titanium or tantalum by way of example. A main layer of the emitter electrode 21 may be made of, for example, tungsten or tungsten-based metals, aluminium, copper, or alloys of aluminium and copper. The collector electrode 19 may comprise aluminium, copper, alloys of aluminium or copper, or multiple layers of metals, e.g. Al/Ti/Ni/Ag or Al/Ni/Ag, etc. Although the electrical connections among the active gate electrodes 10 are not explicitly shown in the cross-sectional perspective provided by Figure 1, the gate electrodes 10 can be shorted together in the third dimension relative to the cross-sectional plane of Figure 1.

An interlay dielectric 23 covers an upper portion of the active cells 15. Therefore, the interlay dielectric 23 electrically isolates the active gate electrodes 10 from the emitter electrode 21. The emitter electrode 21 includes vertical connectors 22 which extend through the interlay dielectric 23 to form an electrical connection with the emitter regions 7 and the P type active base regions 5-i. A heavily doped P+ type region 8 is further provided at the interface between each vertical connector 22 and the corresponding P type active base region 5-i, so as to reduce the contact resistance between the connector 22 and the active base region 5-i. The reduced contact resistance is useful in that it allows excess holes injected from the P+ type collector layer 3 into the N- drift layer 4 during an on-state of the IGBT 1 to easily flow towards the emitter electrode 21.

As shown in Figure 1, each active cell has a first length L1 along the X axis, and each insulation trench has a second length L2 along the X axis. The lengths L1 and L2 satisfy the design rule of 0.5 ≤ L2/L1 ≤ 2. More preferably, the lengths L1 and L2 satisfy the design rule of L2/L1 ≤ 1.7 or most preferably L2/L1 ≤ 1.5, and/or L2/L1 ≥ 1.

The particular design rules between L1 and L2 are advantageous for keeping uniform electric field distribution on the chip front side, and accordingly improve the reliability of the IGBT 1. The chip front side refers to the top surface of a wafer on which the IGBT 1 is manufactured. If L2 is too long with respect to L1, the bottom of the insulation trenches 17 could suffer from higher electric field when the IGBT 1 is reversed biased (i.e., when V_{GE}=0 and V_{CE} is of a positive potential) thereby lowering the breakdown voltage of the IGBT 1. On the other hand, if L2 is too short with respect to L1, the IGBT 1 may suffer from higher short circuit current, thereby worsening the SCSOA performance of the IGBT 1.

Further, the particular design rules are useful for maintaining process uniformity and controllability. As described below in more detail, a semiconductor substrate may be etched to provide the insulation trenches 17 and the active gate trenches 9 simultaneously in a single dry etching step. With L2 being no longer than two times of L1, the lengths L1 and L2 are of comparable scales. As such, the etching depths of the semiconductor substrate may be maintained uniformly across the chip area. This means that the insulation trenches 17 and the active gate trenches 9 would have substantially the same depth along the Y axis. In addition, if L2 is too long with respect to L1, it may be difficult to control the process of filling the insulation trenches 17 with the dielectric material.

As described in more detail below, the insulation trenches 17 were formed by selectively etching the P type base layer 5 and the N- drift layer 4. The sidewalls of the insulation trenches 17 are parallel to the vertical Y axis as shown in Figure 1. This may be achieved by anisotropic dry etching. It would be appreciated that the sidewalls of the insulation trenches 17 may form a small angle (e.g., less than 5°) with respect to the Y axis. In that case, the first length L1 may be an average length of an active cell 15, taking into account the length variations along the Y axis. Similarly, the second length L2 may be an average length of a single insulation trench 17, taking into account the length variations along the Y axis.

By adjusting the second length L2 of the insulation trenches 17, it is possible to adjust the current density of the IGBT 1, so as to meet a predefined performance requirement. For example, an IGBT may be required to deliver 200A current within a chip area of 1cm*1cm. The required current density may be achieved by adjusting the ratio between the second length L2 and the first length L1.

In prior designs of IGBT, dummy semiconductor regions (also referred to as dummy regions) are commonly provided between adjacent active cells. The known dummy regions typically include a P type dummy base region (which is similar to a part of the P type base layer 5 of the IGBT 1, and may also be referred to as a dummy P well). The dummy base region is usually kept floating, meaning that it is not electronically connected to any electrode and thus has a floating potential. An example of the dummy region is for example shown as the P region 13 in Fig. 9 of US Patent US9478614B2. Alternatively, the dummy base region may be grounded or partially grounded. The known dummy regions may also include one or more dummy gate trenches within the dummy base region. The dummy gate trench may be similar to the active gate trench 9 of the IGBT 1 but without any associated emitter regions. An example of the dummy gate trench is shown as the trench 65 in Fig. 9 of US Patent US9478614B2.

As compared to the known dummy regions, the use of the insulation trenches 17 between adjacent active cells 15 are advantageous for improving the SOA of the IGBT 1. This is explained in more detail below.

During an on state of the IGBT 1, the P+ type collector layer 3 injects a large amount of excess holes into the N- drift layer 4. Consequently, the carrier concentration in the highly-resistive N- drift layer 4 increases, causing its resistivity to decrease. This temporary increase in conductivity (i.e., a reduction in resistivity) during a conduction period is called conductivity modulation. When the IGBT 1 is switched from an on state to an off state, the excess holes in the N- drift layer 4 either flow into the emitter electrode 21, or are annihilated with excess electrons due to recombination. However, for the prior designs of IGBT which provides a dummy base region between adjacent active cells, the excess holes tend to accumulate within the dummy base region, causing the potential of the dummy base region to rise. The rising potential in the dummy base region may cause dynamic avalanche in the IGBT and thus limit the SOA of the IGBT. By using the insulation trenches 17 to replace the dummy base regions, the IGBT 1 of the present disclosure significantly reduces the accumulation of the excess holes within the substrate 2 when the IGBT 1 is switched from an on state to an off state. Accordingly, the IGBT 1 has a reduced risk of dynamic avalanche and an improved SOA.

The use of the insulation trenches 17 between adjacent active cells 15 are also advantageous for improving the switching controllability and reducing switching loss and the EMI noise of the IGBT 1. This is explained in more detail below.

The gate capacitance of an IGBT affects the switching loss and the switching controllability of an IGBT. The gate capacitance includes the gate-emitter capacitance (C_{GE}) and the miller capacitance (C_{GC}).

By providing the insulation trenches 17 between neighbouring ones of the active cells 15, the gate-emitter capacitance (C_{GE}) of the IGBT 1 is significantly reduced by an amount which is equal to the gate-emitter capacitance (C_{GE}) of a trench gate structure (either an active trench gate or a dummy trench gate) which otherwise could be provided at the locations of the insulation trenches 17.

The Miller capacitance C_{GC} exists due to the internal structure of an IGBT, and can be considered as including two individual capacitances arranged in series. The first capacitance results from to the oxide layer (e.g., the gate insulator 11) of the gate and has a constant value. The second capacitance represents the capacitive coupling between the collector and the emitter. Being a thick dielectric layer, the insulation trenches 17 significantly reduce the capacitive coupling between the emitter electrode 21 and the collector electrode 19. Therefore, the use of the insulation trenches 17 is also beneficial for reducing the miller capacitance of the IGBT.

Since the use of the insulation trenches 17 reduce both the gate-emitter capacitance (C_{GE}) and the miller capacitance (C_{GC}), the gate capacitance of the IGBT 1 can be charged and discharged at a faster speed than the prior designs, thereby achieving a reduced switching loss and an improved switching controllability.

Further, in the prior IGBT designs, there are significant parasitic capacitances associated with the dummy base regions and the dummy gate trenches, and the parasitic capacitances cause oscillations and create unpleasant noises during the on/off switching of the IGBT 1. By using the insulation trenches 17 to replace the dummy base regions and the dummy gate trenches, the parasitic capacitances within the device are reduced, and accordingly the EMI noise generated by the IGBT 1 is reduced.

Therefore, as compared to the prior IGBT designs which provide dummy semiconductor regions between neighbouring active cells, the use of the insulation trenches 17 to replace such dummy regions improves the SOA and the switching controllability, and reduces switching loss and the EMI noise of the IGBT 1, while providing a similar level of current density. The length L2 of the insulation trenches 17 along the X axis follows the design rule of 0.5 ≤ L2/L1 ≤ 2 to keep uniform electric field distribution on the chip front side (thereby improving the reliability of the IGBT 1) and to maintain process uniformity and controllability.

In addition, the N type first implant zones 13 are useful for improving the conductivity modulation in the IGBT 1 by enhancing the carrier profile in the N- type drift layer 4 in an on state, thereby advantageously reducing V_{CE,sat} of the IGBT 1. Therefore, the IGBT 1 presents an improved trade-off performance amongst the on-state voltage drop V_{CE,sat}, the switching loss E_{SW} and the safe operation area SOA. The IGBT 1 provides an improved efficiency as well as an improved reliability as compared to prior designs of IGBTs.

Further, the first implant zones 13 together with the insulation trenches 17 advantageously enable concurrent improvements in V_{CE,sat} and SOA of the IGBT 1 as compared to prior IGBT designs in which active cells are immediately next to each other. More specifically, by providing the insulation trenches 17 between neighbouring ones of the active cells 15, the IGBT 1 has a reduced channel density relative to a typical IGBT design. The reduced channel density results in an improved SOA (in particular, SCSOA). Normally, the reduced channel density would also cause an increase of V_{CE,sat}. However, with the first implant zone 13, it is possible to maintain V_{CE,sat} at the same level or even to reduce V_{CE,sat} as compared to the prior designs.

The N type buffer layer 6 may also be referred to as a field stop layer, because it terminates the electrical field within the IGBT 1. The buffer layer 6 is useful for reducing the on-state voltage drop V_{CE,sat} of the IGBT 1, and makes the IGBT 1 a punch-through (PT) IGBT. It would be appreciated that the N type buffer layer 6 may be omitted. It would further be appreciated that the first implant zones 13 may also be omitted.

Figure 2 schematically illustrates a cross-sectional view of a trench-gate IGBT 1A according to a second embodiment of the present disclosure. The second embodiment does not form part of the claimed invention but it is useful for its understanding. Elements of the IGBT 1A that are identical to those of the IGBT 1 are identified using the same labels. Elements of the IGBT 1A that correspond to, but are different from those of the IGBT 1 are labelled using the same numerals but with a letter 'A' for differentiation. The features and advantages described above with reference to the first embodiment are generally applicable to the second embodiment.

The IGBT 1A includes a plurality of active cells 15A and a plurality of insulation trenches 17. In contrast to the active cells 15 each of which provides two current channels at opposite sides of the respective active gate trench 9, each active cell 15A provides a single current channel at one side of its active gate trench 9. As shown in Figure 2, each active cell 15A includes a P type active base region 5-i and a first implant zone 13 at one side of the respective active gate trench 9, and includes a P type dummy base region 5-ii and a first implant zone 13 at the other side of the active gate trench 9. Each of the active base regions 5-i and the dummy base regions 5-ii is part of the P type base layer 5. Emitter regions 7 are only provided within the active base regions 5-i. When the IGBT 1A is in an on state, there is no current flowing through the dummy base regions 5-ii, but there is current flowing through the active base region 5-i. Each of the gate trenches 9 shown in Figure 2 is a control electrode, which controls the on/off of the current channel of the respective active cell 15. Therefore, all of the gate trenches of the IGBT 1A are active gate trenches. In this sense, all of the cells 15A are active cells because of their ability to conduct current during the on state. The dummy base regions 5-ii may also be referred to as dummy wells.

The dummy base regions 5-ii may have a floating potential. Alternatively, the dummy base regions 5-ii may be electrically connected to the emitter electrode 21 (which is normally grounded for an N-channel IGBT such as the IGBT 1A).

Further, although Figure 2 shows that the active base region 5-i and the dummy base region 5-ii have the same length along the X axis, it would be understood that this is not necessary and that their lengths may be different along the X axis. It would also be understood that the first implant zones 13 between the dummy base regions 5-ii and the N- drift layer 4 may be omitted.

It would be understood that with the same lengths L1 and L2, the IGBT 1A has a lower channel density than the IGBT 1 due to the fact that there is no current flowing through the dummy base regions 5-ii during the on state of the IGBT 1A. Accordingly, the IGBT 1A generally provides a lower current density, which is approximately a half of the current density achievable by the IGBT 1. Therefore, the IGBT 1A is useful for applications requiring a lower current density.

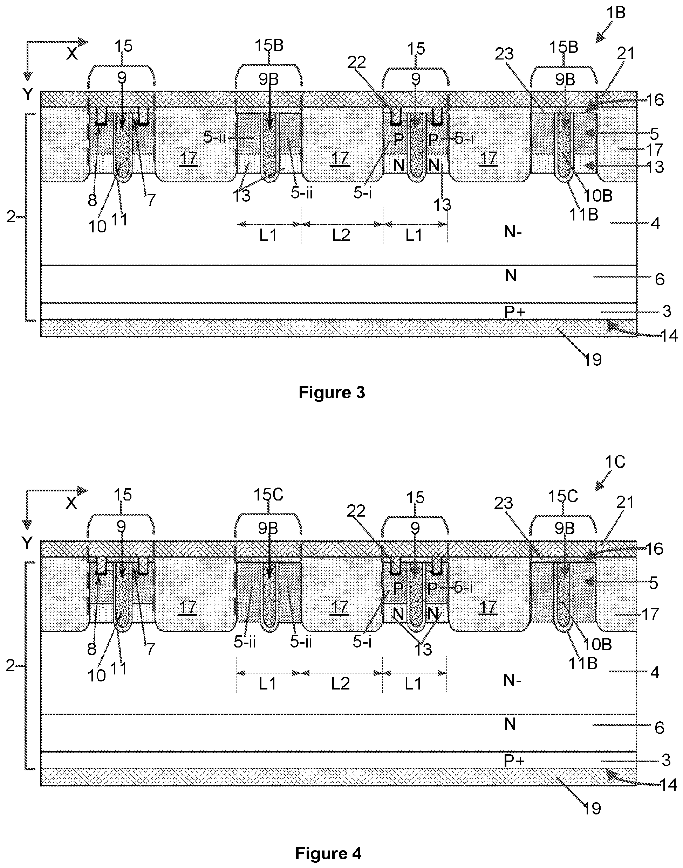

Figure 3 schematically illustrates a cross-sectional view of a trench-gate IGBT 1B according to a third, and claimed, embodiment of the present disclosure. Elements of the IGBT 1B that are identical to those of the IGBT 1 or the IGBT 1A are identified using the same labels. Elements of the IGBT 1B that correspond to, but are different from those of the IGBT 1 or the IGBT 1A are labelled using the same numerals but with a letter 'B' for differentiation. The features and advantages described above with reference to the first embodiment are generally applicable to the third embodiment.

In the IGBT 1B, a plurality of active cells 15, a plurality of insulation trenches 17 as well as a plurality of dummy cells 15B are formed within the semiconductor substrate 2. As illustrated in Figure 3, a single dummy cell 15B is provided between two adjacent active cells 15 along the X axis. The dummy cells 15B are semiconductor regions formed in the substrate 2. A single insulation trench 17 is used to isolate any dummy cell 15B from its neighbouring active cells 15. In this way, a combination of two insulation trenches 17 and a dummy cell 15B are provided immediately between two adjacent active cells 15 along the X axis.

It would be appreciated that more than one dummy cell 15B may be provided between two adjacent active cells 15. In that case, an insulation trench 17 would be provided between each dummy cell 15B and its neighbouring dummy or active cell so as to isolate the cells (whether active or dummy) from one another. In other words, a combination of M (M being an integer ≥ 2) dummy cell 15B and M+1 insulation trenches 17 may be provided immediately between two adjacent active cells 15 along the X axis.

As described above, the expression "active cell" means that the respective cell would provide at least one conducting channel during an on-state of the IGBT. Conversely, the expression "dummy cell" means that the respective cell would not be able to provide any conducting current channel during the on state of the IGBT. Each dummy cell 15B comprises a dummy gate trench 9B. Each dummy gate trench 9B comprises a gate insulator 11B which for example may be a thin layer of oxide film, and a dummy gate electrode 10B which for example may be made of polysilicon. The expressions "dummy gate electrode" and "dummy gate trench" mean that the respective gate electrode within the corresponding gate trench is not a control electrode, and cannot be used to control the on/off switching of any current channel of the IGBT 1B.

As shown in Figure 3, each dummy cell 15B further comprises a P type dummy base region 5-ii and a first implant zone 13 at either side of the dummy gate trench 9B. A first implant zone 13 is provided between a P type dummy base region 5-ii and the N-drift layer 4. All of the first implant zones 13 within the active and dummy cells may be formed in the substrate 2 simultaneously by one implantation step. Similar to the active base regions 5-i of the active cells 15, the dummy base regions 5-ii are part of the P type base layer 5.

There is no emitter region within any of the dummy base regions 5-ii. Therefore, there is no current channel flowing through any of the dummy cells 15B during the on state of the IGBT 1B. However, each active cell 15 is able to provide two current channels along the two sidewalls of the active gate trench 9.

As shown in Figure 3, each dummy cell 15B has a length L1 along the X axis which is identical to the length L1 of an active cell 15. Further, each dummy gate trench 9B have the same dimension as the active gate trench 9, and each dummy base regions 5-ii is also designed to have the same dimension and the same doping concentration as the active base regions 5-i.

The lengths L1 and L2 in the IGBT 1B still satisfy the design rule of 0.5 ≤ L2/L1 ≤ 2. More preferably, the lengths L1 and L2 satisfy the design rule of L2/L1 ≤ 1.7, or most preferably L2/L1 ≤ 1.5, and/or L2/L1 ≥ 1. Since the dummy cells 15B and the active cells 15 are both semiconductor regions formed in the substrate 2 and are designed to have very similar structures and configurations, the particular design rules between L1 and L2 remains useful for keeping uniform electric field distribution on the chip front side, and for maintaining process uniformity and controllability.

It would be understood that with the same lengths L1 and L2, the IGBT 1B has a lower channel density than the IGBT 1 due to the fact that the dummy cells 15B do not provide any conducting channel during the on state of the IGBT 1B. Accordingly, the IGBT 1B generally provides a lower current density, which is approximately a half of the current density achievable by the IGBT 1. Therefore, the IGBT 1B is useful for applications requiring a lower current density.

As described above, the IGBT 1 uses its insulation trenches 17 to replace the entirety of the dummy semiconductor regions used in prior designs. Turning to Figure 3, it is clear that the IGBT 1B uses its insulation trenches 17 to replace a substantial part (e.g., more than two thirds in the example provided by Figure 3) of the dummy semiconductor regions used in prior designs. As a result, the IGBT 1B still has a reduced amount of excess holes accumulated within the substrate 2 (in particular in the dummy base regions 5-ii) when the IGBT 1B is switched from an on state to an off state. Accordingly, the IGBT 1B has a reduced risk of dynamic avalanche and an improved SOA. Further, by using the insulation trenches 17 to replace a substantial part of the dummy semiconductor regions used in prior designs, the IGBT 1B has a reduced gate-emitter capacitance (C_{GE}) and a reduced Miller capacitance C_{GC} as compared to prior designs for similar reasons as described above for the first embodiment. Consequently, the insulation trenches 17 are also advantageous for improving the switching controllability and reducing switching loss and the EMI noise of the IGBT 1B.

The dummy base regions 5-ii and the dummy gate electrodes 10B of the IGBT 1B may be electrically connected to the emitter electrode 21 which is normally grounded, or may be floating. Alternatively, dummy gate electrodes 10B may be electrically connected to the active gate electrode.

It would be appreciated that, according to an example useful for understanding the invention, the dummy gate trench 9B (including the gate insulator 11B and the dummy gate electrode 10B) may be omitted such that each dummy cell 15B only includes the dummy base region 5-ii and the first implant zone 13. In that case, each of the dummy base region 5-ii and the first implant zone 13 would have a length equal to L1 along the X axis.

Figure 4 schematically illustrates a cross-sectional view of a trench-gate IGBT 1C according to a fourth, and claimed, embodiment of the present disclosure. Elements of the IGBT 1C that are identical to those of the IGBTs 1, 1A, 1B are identified using the same labels. Elements of the IGBT 1C that correspond to, but are different from those of the IGBTs 1, 1A, 1B are labelled using the same numerals but with a letter 'C' for differentiation. The features and advantages described above with reference to the first embodiment are generally applicable to the fourth embodiment.

The structure of the IGBT 1C is similar to that of the IGBT 1B. However, the dummy cells 15C of the IGBT 1C do not have any of the first implant zones 13.

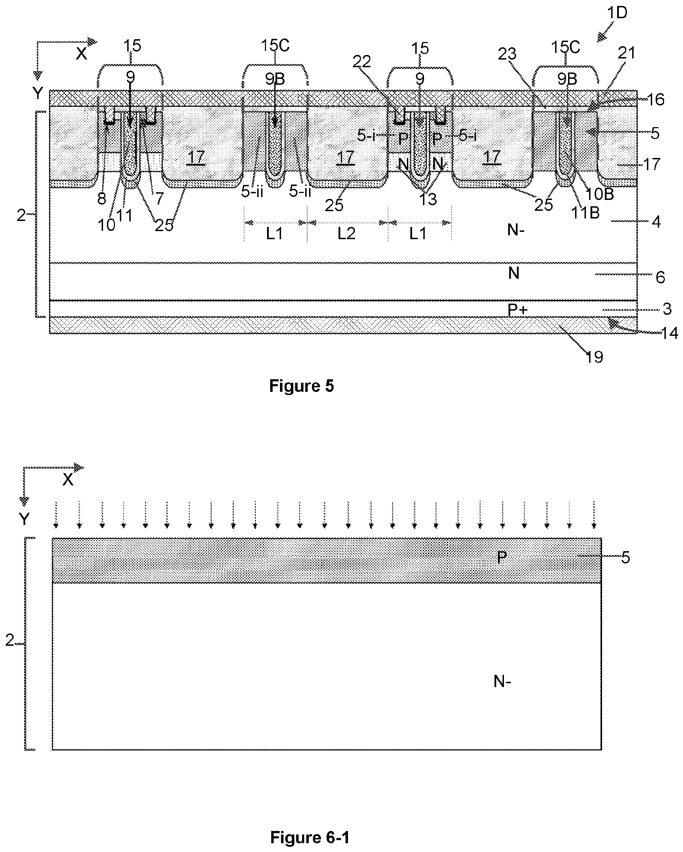

Figure 5 schematically illustrates a cross-sectional view of a trench-gate IGBT 1D according to a fifth, and claimed, embodiment of the present disclosure. Elements of the IGBT 1D that are identical to those of the IGBTs described above are identified using the same labels. Elements of the IGBT 1D that correspond to, but are different from those of the IGBTs described above are labelled using the same numerals but with a letter 'D' for differentiation. The features and advantages described above with reference to the first embodiment are generally applicable to the fifth embodiment.

As compared to the IGBT 1C, the IGBT 1D has additional second implant zones 25. The second implant zones 25 are P type, and are formed by implantation. Therefore, all of the second implant zones 25 may be formed in the substrate 2 simultaneously. As shown in Figure 5, some of the second implant zones 25 are provided under the gate trenches 9, 9B, i.e., between the gate trenches 9, 9B and the N- drift layer 4.

The second implant zones 25 under the gate trenches 9, 9B are useful in that they shield the bottom of the gate trenches 9, 9B from the bombing holes injected by the P+ collector layer 3 during an on state of the IGBT 1D. Accordingly, the gate trenches 9, 9B are protected by the second implant zones 25 from trapping holes bombing from the collector layer 3. As a result, the second implant zones 25 under the gate trenches 9, 9B (in particular, the active gate trenches 9) improve the reliability of the IGBT 1D. Further, the second implant zones 25 under the gate trenches 9, 9B provide better blocking capability. Being P type, the second implant zones 25 under the gate trenches 9, 9B are useful for depleting the N- drift layer 4 in the blocking state, thereby supporting a high breakdown voltage for the IGBT 1D.

The second implant zones 25 under the gate trenches 9, 9B may be floating, i.e., not electrically connected to any electrodes of the IGBT 1D.

As further shown in Figure 5, the second implant zones 25 are also provided under the insulation trenches 17, i.e., between the insulation trenches 17 and the N- drift layer 4.

Such implant zones 25 are also useful for depleting the N- drift layer 4 in the blocking state, thereby supporting a high breakdown voltage for the IGBT 1D.

The second implant zones 25 under the insulation trenches 17 may be electrically connected to the emitter electrode 21 which is normally grounded.

It would be appreciated that the second implant zones 25 may be provided within each of the IGBTs 1, 1A, 1B and 1C described above. It would also be appreciated that the second implant zones 25 between the insulation trenches 17 and the N- drift layer 4 may be omitted, such that the second implant zones 25 are only formed under the gate trenches 9 and 9B. It would further be understood that the second implant zones 25 under the dummy gate trenches 9B may also be omitted, such that the second implant zones 25 are only formed under the active gate trenches 9.

The IGBTs described above are all N-channel IGBTs. It would be appreciated that the doping types of each region/layer may be changed to the opposite doping types so as to provide P-channel IGBTs.

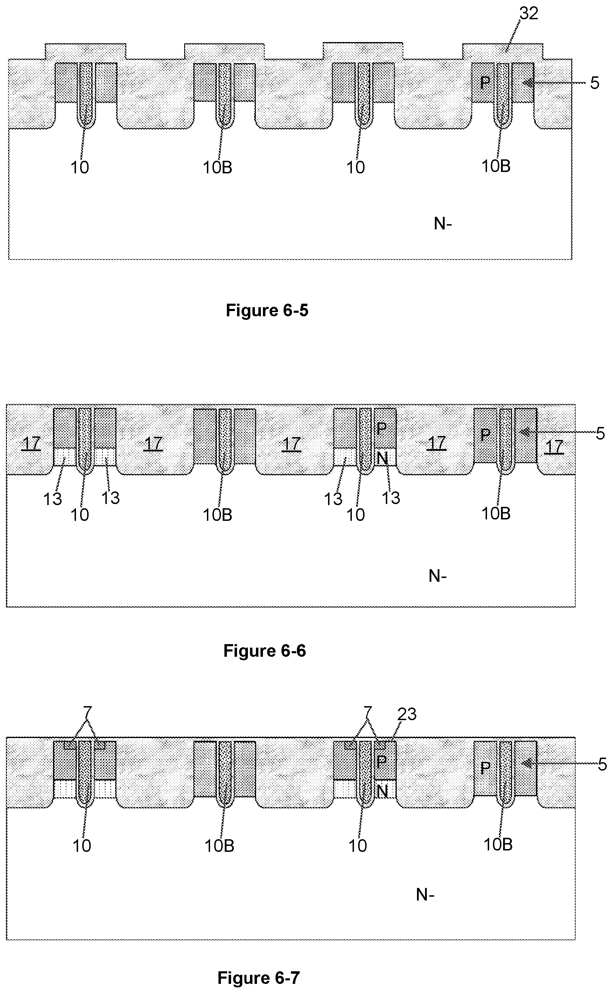

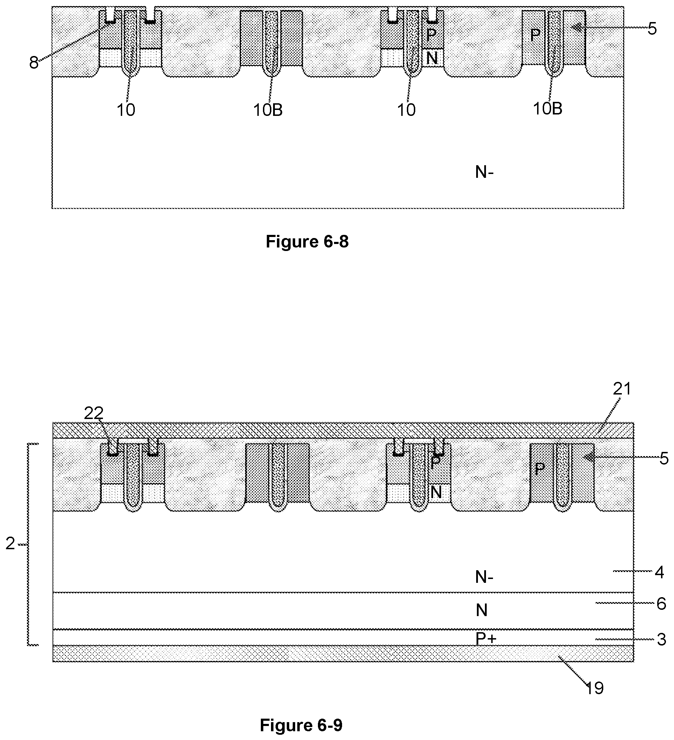

Figures 6-1 to 6-9 illustrate a method for manufacturing the IGBT 1C of the fourth embodiment.

At the first step as illustrated by Figure 6-1, P type dopants (such as, Boron) are implanted into a semiconductor substrate 2 to form a P type base layer 5 at a top side of the substrate. The semiconductor substrate 2 is a lightly doped N- type substrate, which has a doping concentration corresponding to the doping concentration of the N-drift layer 4. The semiconductor substrate 2 is made of a single-crystalline semiconductor material, which may be, for example, silicon (Si), silicon carbide (SiC), germanium (Ge), or a silicon germanium crystal (SiGe). Dimensions and doping concentrations given in the following refer to silicon IGBTs, by way of example.

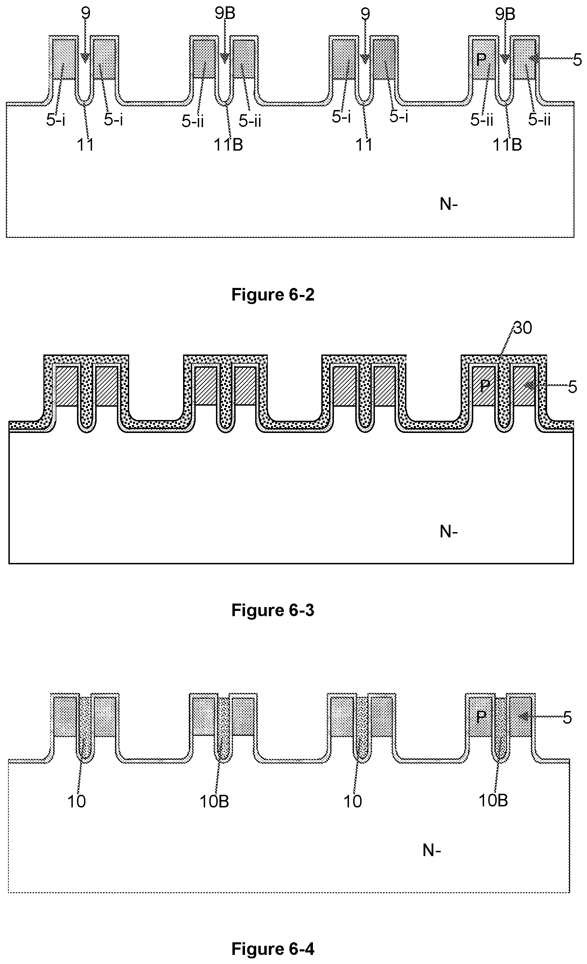

At the second step as illustrated by Figure 6-2, the top side of the substrate 2 is selectively etched to form trenches in the substrate 2. The trenches provide the gate trenches 9, 9B and the insulation trenches 17 in the finished product. Anisotropic dry etching may be used at this step in order to provide vertical sidewalls of the trenches. The etching depth may be between 3 micrometres (*µm*) to 7 *µm*. A gate oxide layer (e.g., silicon dioxide) is then thermally grown on the surfaces of the substrate 2. The gate oxide layer provides the gate insulators 11, 11B. The thickness of the gate oxide layer may be between 900Å to 1300Å. Before the gate oxide layer is grown, steps of growing and removing a sacrificial gate oxide layer may be optionally performed. The thickness of the sacrificial gate oxide layer may be between 1000Å to 3000Å. It would be understood that during the thermal growth of the gate oxide layer and/or the sacrificial gate oxide layer, the dopants implanted at the first step would move to a deeper depth of the substrate 2 to form the active base regions 5-i and the dummy base regions 5-ii.

After the gate oxide layer 11, 11B is formed, another implantation step (not shown in Figure 6-2) may be performed to provide the second implant zones 25 required by the IGBT 1D according to the fifth embodiment. In particular, P type dopants (e.g., Boron) may be selectively implanted with a dose of 1 × 10¹² *to* 1 × 10¹⁴ *ions*/*cm*² , an ion energy of 50~400keV and a tile angle of 0 degree, so as to form the P type implant zone 25 under the gate trenches 9, 9B and the insulation trenches 17.

At the third step as illustrated by Figure 6-3, a layer of polysilicon 30 is deposited on the top surface of the substrate 2 to fill the gate trenches 9, 9B.

At the fourth step as illustrated by Figure 6-4, the deposited polysilicon which is outside of the gate trenches 9, 9B are etched off. In this way, the remaining polysilicon forms the active gate electrodes 10 and the dummy gate electrodes 10B. At the fifth step as illustrated by Figure 6-5, a thick layer of dielectric material (e.g. silicon dioxide) is deposited on the top surface of the substrate 2 to fill the insulation trenches 17.

At the sixth step as illustrated by Figure 6-6, a chemical mechanical polishing (CMP) process is employed to smooth the top surface of the substrate 2, followed by wet cleaning of the substrate 2. Subsequently, another layer of dielectric material (e.g., silicon dioxide) is deposited on the top surface of the substrate 2. The thickness of that layer may be between 200Å~800Å.

Further, N type dopants (e.g., Phosphorous) are selectively implanted into the substrate 2 with a high ion energy (e.g., >2.0MeV) to form the first implant zones 13 within the active cells 15. Thermal annealing follows to activate the implanted N type dopants. High ion energy is required because of the depth of the first implant zones 13 within the substrate 2.

At the seventh step as illustrated by Figure 6-7, N type dopants (e.g., Arsenic or Phosphorous) are selectively implanted into the base layer 5 to form the emitter regions 7 within the active cells 15. The dielectric layer (e.g., silicon dioxide) previously deposited on the top surface of the substrate 2 is then cleaned. A further layer of dielectric material (e.g., silicon dioxide) with an exemplary thickness of greater than 0.6um is then deposited on the top surface of the substrate to form the interlay dielectric 23.

At the eighth step as illustrated by Figure 6-8, the interlay dielectric 23 and the base layer 5 are selectively etched, for example, by an etching depth of 0.3-0.5 *µm*. P type dopants (e.g., Boron) are then implanted and thermally annealed to form the P+ type contact regions 8.

At the ninth step as illustrated by Figure 6-9, metal is deposited on the top surface of the substrate 2 to form the emitter electrode 21 with the vertical connectors 22. The bottom side of the substrate 2 may be grinded to a target wafer thickness as required, and is then doped to form the N type buffer layer 6 and the P+ type collector layer 3. Metal is further deposited on the bottom surface of the substrate 2 to form the collector electrode 19. The process carried out to the bottom side of the substrate 2 may be performed during or after the above described processing steps carried out to the top side.

While the above paragraphs only describe the methods for manufacturing the IGBTs 1C and 1D, it would be understood that the described methods may be easily adapted (by for example modifying the masks used during the implantation and etching steps) in order to manufacture the IGBTs of other embodiments.

While the embodiments described above refer to IGBTs only, it would be appreciated that the present disclosure may be applied to other types of power semiconductor devices.

The skilled person will understand that in the preceding description and appended claims, positional terms such as 'top', 'bottom', 'under', 'lateral', 'vertical', etc. are made with reference to conceptual illustrations of a power semiconductor device, such as those showing standard cross sectional views and those shown in the appended drawings. These terms are used for ease of reference but are not intended to be of limiting nature. These terms are therefore to be understood as referring to a semiconductor structure when in an orientation as shown in the accompanying drawings.

Although the disclosure has been described in terms of preferred embodiments as set forth above, it should be understood that these embodiments are illustrative only. Those skilled in the art will be able to make modifications and alternatives in view of the disclosure which are contemplated as falling within the scope of the appended claims. Each feature disclosed or illustrated in the present specification may be incorporated in the disclosure, whether alone or in any appropriate combination with any other feature disclosed or illustrated herein.

## Claims

1. A power semiconductor device (1B), comprising:
a semiconductor substrate (2) comprising:
a base layer (5) selectively provided at a first side of the semiconductor substrate, and wherein the base layer has a first conductivity type;
a collector layer (3) provided at a second side of the semiconductor substrate, wherein the second side is opposite to the first side, and wherein the collector layer has the first conductivity type; and
a drift layer (4) having a second conductivity type opposite to the first conductivity type, wherein the drift layer is arranged between the collector layer and the base layer;
a plurality of active cells (15) provided in the semiconductor substrate, wherein each of the active cells comprises an emitter region which has the second conductivity type, an active base region which is a part of the base layer, an active gate trench (9) comprising a gate insulator (11) and an active gate electrode (10) disposed therein, and wherein the active gate trench is configured to extend from a surface of the semiconductor substrate at the first side into the drift layer along a first direction; and
a plurality of insulation trenches (17) provided in the substrate, each insulation trench neighbouring at least one of the active cells, wherein each of the insulation trenches is filled with a dielectric material, wherein each of the plurality of active cells has a first length L1 along a second direction perpendicular to the first direction, and each of the plurality of insulation trenches has a second length L2 along the second direction, and the first and second lengths L1 and L2 satisfy the relationship of 0.5 ≤ L2/L1 ≤ 2;
wherein the power semiconductor device comprises:
a plurality of dummy cells (15B), wherein each dummy cell comprises a dummy base region which is a part of the base layer, and wherein each of the plurality of dummy cells has the first length L1 along the second direction; and
wherein at least two of the plurality of isolation trenches are positioned between neighbouring active cells along the second direction, and wherein each of the dummy cells is provided between the at least two isolation trenches along the second direction.

2. A power semiconductor device according to claim 1, wherein the first and second lengths L1 and L2 further satisfy the relationship of L2/L1 ≤ 1.7.

3. A power semiconductor device according to claim 1 or 2, wherein each of the plurality of active cells further comprises a first implant zone (13) provided between the active base region and the drift layer, wherein the first implant zone is of the second conductivity type and has a higher doping concentration than the drift layer; and
optionally wherein the active gate trench is configured to extend through the base layer and the first implant zone into the drift layer.

4. A power semiconductor device according to any preceding claim, wherein
(i) the insulation trenches are filled exclusively with the dielectric material; and/or
(ii) the insulation trenches are configured to extend from the surface of the semiconductor substrate at the first side into the drift layer.

5. A power semiconductor device according to any preceding claim, further comprising an emitter electrode (21) which is electrically connected to the emitter region of each the plurality of active cells and a collector electrode (19) which is electrically connected to collector layer.

6. A power semiconductor device according to any preceding claim, wherein each of the plurality of active cells further comprises a second implant zone (25) between the active gate trench and the drift layer, the second implant zone having the first conductivity type; and
optionally wherein the second implant zone is also provided between the insulation trench and the drift layer.

7. A power semiconductor device according to any preceding claim, wherein the second direction is parallel to the surface of the semiconductor substrate.

8. A power semiconductor device according to any preceding claim, wherein each of the plurality of active cells is configured to provide at least one current channel during an on-state of the power semiconductor device; and
optionally wherein each of the plurality of active cells further comprises one or more of the dummy base regions, and wherein the active base region and the dummy base region are provided at opposite sides of the active gate trench, such that the at least one of the active cells provides a single current channel during the on-state of the power semiconductor device.

9. A power semiconductor device according to any preceding claim, wherein each active gate trench is provided in the middle of its respective active cell of the plurality of active cells along the second direction.

10. A power semiconductor device according to any preceding claim, wherein each of the plurality of dummy cells further comprises a dummy gate trench (9B) which comprises a gate insulator and a dummy gate electrode (10B) disposed therein; and
optionally wherein the dummy gate trench has the same dimension as the active gate trench.

11. A power semiconductor device according to claim 3, wherein the first implant zone is provided within each of the plurality of the dummy cells between the dummy base region and the drift layer.

12. A power semiconductor device according to claim 10 as dependent from claim 6, wherein the second implant zone is provided within each of the plurality of dummy cells between the dummy gate trench and the drift layer.

13. A power semiconductor device according to any preceding claim, further comprising a buffer layer (6) having the second conductivity type, wherein the buffer layer is provided between the drift layer and the collector layer, and has a higher doping concentration than the drift layer.

14. A method of manufacturing a power semiconductor device (1B), the method comprising:
providing a semiconductor substrate (2) comprising:
a base (5) layer provided at a first side of the semiconductor substrate, wherein the base layer has a first conductivity type; and
a drift layer (4) having a second conductivity type opposite to the first conductivity type;
selectively etching the base layer and the drift layer to form an active gate trench (9) and a plurality of insulation trenches (17) within the semiconductor substrate;
forming a gate insulator (11) within the active gate trench;
forming an active gate electrode (10) within the active gate trench;
filling each of the insulation trenches with a dielectric material;
selectively forming an emitter region having the second conductivity type within the base layer at the first side of the semiconductor substrate, wherein the emitter region, a part of the base layer in which the emitter region is provided, and the active gate trench with the gate insulator and the active gate electrode collectively provide a plurality of active cells (15), and wherein each insulation trench neighbours at least one of the active cells; and
forming a collector layer (3) at a second side of the semiconductor substrate, the collector layer having the first conductivity type, wherein the second side is opposite to the first side, and the drift layer is arranged between the collector layer and the base layer;
wherein:
the active gate trench is configured to extend from a surface of the semiconductor substrate at the first side into the drift layer along a first direction;
wherein each active cell has a first length L1 along a second direction perpendicular to the first direction, and each insulation trench has a second length L2 along the second direction; and
the first and second lengths L1 and L2 satisfy the relationship of 0.5 ≤ L2/L1 ≤ 2;
the method comprising forming a plurality of dummy cells (15B), each dummy cell comprising a dummy base region which is a part of the base layer, wherein each dummy cell has the first length L1 along the second direction; and
wherein at least two of the isolation trenches are positioned between neighbouring active cells in the second dimension, and wherein each of the dummy cells is provided between the at least two isolation trenches along the second direction.

## Patentansprüche

1. Leistungshalbleitervorrichtung (1B), umfassend:
ein Halbleitersubstrat (2), umfassend:
eine Basisschicht (5), die selektiv auf einer ersten Seite des Halbleitersubstrats bereitgestellt ist, und wobei die Basisschicht einen ersten Leitfähigkeitstyp aufweist;
eine Kollektorschicht (3), die auf einer zweiten Seite des Halbleitersubstrats bereitgestellt ist, wobei die zweite Seite der ersten Seite gegenüberliegt, und wobei die Kollektorschicht den ersten Leitfähigkeitstyp aufweist; und
eine Driftschicht (4), die einen zweiten Leitfähigkeitstyp aufweist, der dem ersten Leitfähigkeitstyp entgegengesetzt ist, wobei die Driftschicht zwischen der Kollektorschicht und der Basisschicht angeordnet ist;
eine Vielzahl von aktiven Zellen (15), die im Halbleitersubstrat bereitgestellt ist, wobei jede der aktiven Zellen einen Emitterbereich, der den zweiten Leitfähigkeitstyp aufweist, einen aktiven Basisbereich, der ein Teil der Basisschicht ist, einen aktiven Gate-Graben (9), der einen Gate-Isolator (11) und eine darin angeordnete aktive Gate-Elektrode (10) aufweist, umfasst, und wobei der aktive Gate-Graben konfiguriert ist, sich von einer Oberfläche des Halbleitersubstrats an der ersten Seite entlang einer ersten Richtung in die Driftschicht zu erstrecken; und
eine Vielzahl von Isolationsgräben (17), die im Substrat bereitgestellt ist, wobei jeder Isolationsgraben zu mindestens einer der aktiven Zellen benachbart liegt, wobei jeder der Isolationsgräben mit einem dielektrischen Material gefüllt ist, wobei jede der aktiven Zellen eine erste Länge L1 entlang einer zweiten Richtung aufweist, die senkrecht zur ersten Richtung ist, und jeder der Isolationsgräben eine zweite Länge L2 entlang der zweiten Richtung aufweist, und die erste und die zweite Länge L1 und L2 die Beziehung 0,5 ≤ L2/L1 ≤ 2 erfüllen;
wobei die Leistungshalbleitervorrichtung Folgendes umfasst:
eine Vielzahl von Dummyzellen (15B), wobei jede Dummyzelle einen Dummybasisbereich umfasst, der ein Teil der Basisschicht ist, und wobei jede der Vielzahl von Dummyzellen die erste Länge L1 entlang der zweiten Richtung aufweist; und
wobei mindestens zwei der Vielzahl von Isolationsgräben zwischen benachbarten aktiven Zellen entlang der zweiten Richtung positioniert sind, und wobei jede der Dummyzellen zwischen den mindestens zwei Isolationsgräben entlang der zweiten Richtung bereitgestellt ist.

2. Leistungshalbleitervorrichtung nach Anspruch 1, wobei die erste und zweite Länge L1 und L2 ferner die Beziehung L2/L1 ≤ 1,7 erfüllen.

3. Leistungshalbleitervorrichtung nach Anspruch 1 oder 2, wobei jede der Vielzahl von aktiven Zellen ferner eine erste Implantationszone (13) umfasst, die zwischen dem aktiven Basisbereich und der Driftschicht bereitgestellt ist, wobei die erste Implantationszone vom zweiten Leitfähigkeitstyp ist und eine höhere Dotierungskonzentration als die Driftschicht aufweist; und
wobei optional der aktive Gate-Graben konfiguriert ist, sich durch die Basisschicht und die erste Implantationszone in die Driftschicht zu erstrecken.

4. Leistungshalbleitervorrichtung nach einem vorstehenden Anspruch, wobei
(i) die Isolationsgräben ausschließlich mit dem dielektrischen Material gefüllt sind; und/oder
(ii) die Isolationsgräben konfiguriert sind, sich von der Oberfläche des Halbleitersubstrats auf der ersten Seite in die Driftschicht zu erstrecken.

5. Leistungshalbleitervorrichtung nach einem vorstehenden Anspruch, ferner umfassend eine Emitterelektrode (21), die elektrisch mit dem Emitterbereich jeder der Vielzahl von aktiven Zellen verbunden ist, und eine Kollektorelektrode (19), die elektrisch mit der Kollektorschicht verbunden ist.

6. Leistungshalbleitervorrichtung nach einem vorstehenden Anspruch, wobei jede der Vielzahl von aktiven Zellen ferner eine zweite Implantationszone (25) zwischen dem aktiven Gate-Graben und der Driftschicht umfasst, wobei die zweite Implantationszone den ersten Leitfähigkeitstyp aufweist; und
wobei optional die zweite Implantationszone auch zwischen dem Isolationsgraben und der Driftschicht bereitgestellt ist.

7. Leistungshalbleitervorrichtung nach einem vorstehenden Anspruch, wobei die zweite Richtung parallel zur Oberfläche des Halbleitersubstrats ist.

8. Leistungshalbleitervorrichtung nach einem vorstehenden Anspruch, wobei jede der Vielzahl von aktiven Zellen konfiguriert ist, während eines eingeschalteten Zustands der Leistungshalbleitervorrichtung mindestens einen Stromkanal bereitzustellen; und
wobei optional jede der Vielzahl von aktiven Zellen ferner einen oder mehrere der Dummybasisbereiche umfasst, und wobei der aktive Basisbereich und der Dummybasisbereich auf gegenüberliegenden Seiten des aktiven Gate-Grabens bereitgestellt sind, sodass die mindestens eine der aktiven Zellen während des eingeschalteten Zustands der Leistungshalbleitervorrichtung einen einzigen Stromkanal bereitstellt.

9. Leistungshalbleitervorrichtung nach einem vorstehenden Anspruch, wobei jeder aktive Gate-Graben in der Mitte seiner jeweiligen aktiven Zelle der Vielzahl von aktiven Zellen entlang der zweiten Richtung bereitgestellt ist.

10. Leistungshalbleitervorrichtung nach einem vorstehenden Anspruch, wobei jede der Vielzahl von Dummyzellen ferner einen Dummy-Gate-Graben (9B) umfasst, der einen Gate-Isolator und eine darin angeordnete Dummy-Gate-Elektrode (10B) umfasst; und
wobei optional der Dummy-Gate-Graben die gleichen Abmessungen wie der aktive Gate-Graben aufweist.

11. Leistungshalbleitervorrichtung nach Anspruch 3, wobei die erste Implantationszone in jeder der Vielzahl von Dummyzellen zwischen dem Dummybasisbereich und der Driftschicht bereitgestellt ist.

12. Leistungshalbleitervorrichtung nach Anspruch 10, sofern von Anspruch 6 abhängig, wobei die zweite Implantationszone in jeder der Vielzahl von Dummyzellen zwischen dem Dummy-Gate-Graben und der Driftschicht bereitgestellt ist.

13. Leistungshalbleitervorrichtung nach einem vorstehenden Anspruch, ferner umfassend eine Pufferschicht (6), die den zweiten Leitfähigkeitstyp aufweist, wobei die Pufferschicht zwischen der Driftschicht und der Kollektorschicht bereitgestellt ist und eine höhere Dotierungskonzentration als die Driftschicht aufweist.

14. Verfahren zum Herstellen einer Leistungshalbleitervorrichtung (1B), wobei das Verfahren umfasst:
Bereitstellen eines Halbleitersubstrats (2), umfassend:
eine Basisschicht (5), die selektiv auf einer ersten Seite des Halbleitersubstrats bereitgestellt ist, wobei die Basisschicht einen ersten Leitfähigkeitstyp aufweist; und
eine Driftschicht (4), die einen zweiten Leitfähigkeitstyp aufweist, der dem ersten Leitfähigkeitstyp entgegengesetzt ist;
selektives Ätzen der Basisschicht und der Driftschicht, um einen aktiven Gate-Graben (9) und eine Vielzahl von Isolationsgräben (17) im Halbleitersubstrat zu bilden;
Bilden eines Gate-Isolators (11) im aktiven Gate-Graben;
Bilden einer aktiven Gate-Elektrode (10) im aktiven Gate-Graben;
Füllen jedes der Isolationsgräben mit einem dielektrischen Material;
selektives Bilden eines Emitterbereichs, der den zweiten Leitfähigkeitstyp aufweist, in der Basisschicht auf der ersten Seite des Halbleitersubstrats, wobei der Emitterbereich, ein Teil der Basisschicht, in dem der Emitterbereich bereitgestellt ist, und der aktive Gate-Graben mit dem Gate-Isolator und der aktiven Gate-Elektrode zusammen eine Vielzahl von aktiven Zellen (15) bereitgestellt, und wobei jeder Isolationsgraben benachbart zu mindestens einer der aktiven Zellen liegt; und
Bilden einer Kollektorschicht (3) auf einer zweiten Seite des Halbleitersubstrats, wobei die Kollektorschicht den ersten Leitfähigkeitstyp aufweist, wobei die zweite Seite der ersten Seite gegenüberliegt, und die Driftschicht zwischen der Kollektorschicht und der Basisschicht angeordnet ist;
wobei:
der aktive Gate-Graben konfiguriert ist, sich von einer Oberfläche des Halbleitersubstrats auf der ersten Seite entlang einer ersten Richtung in die Driftschicht zu erstrecken;
wobei jede aktive Zelle eine erste Länge L1 entlang einer zweiten Richtung senkrecht zur ersten Richtung aufweist und jeder Isolationsgraben eine zweite Länge L2 entlang der zweiten Richtung aufweist; und
die erste und die zweite Länge L1 und L2 die Beziehung 0,5 ≤ L2/L1 ≤ 2 erfüllen;
das Verfahren Bilden einer Vielzahl von Dummyzellen (15B) umfasst, wobei jede Dummyzelle einen Dummybasisbereich umfasst, der ein Teil der Basisschicht ist, wobei jede Dummyzelle die erste Länge L1 entlang der zweiten Richtung aufweist; und
wobei mindestens zwei der Isolationsgräben zwischen benachbarten aktiven Zellen in der zweiten Abmessung positioniert sind, und wobei jede der Dummyzellen zwischen den mindestens zwei Isolationsgräben entlang der zweiten Richtung bereitgestellt ist.

## Revendications

1. Dispositif semi-conducteur de puissance (1B), comprenant :
un substrat semi-conducteur (2) comprenant :
une couche de base (5) sélectivement fournie au niveau d'un premier côté du substrat semi-conducteur, et dans lequel la couche de base présente un premier type de conductivité ;
une couche de collecteur (3) fournie au niveau d'un second côté du substrat semi-conducteur, dans lequel le second côté est opposé au premier côté, et dans lequel la couche de collecteur présente le premier type de conductivité ; et
une couche de dérive (4) présentant un second type de conductivité opposé au premier type de conductivité, dans lequel la couche de dérive est agencée entre la couche de collecteur et la couche de base ;
une pluralité de cellules actives (15) fournies dans le substrat semi-conducteur, dans lequel chacune des cellules actives comprend une région d'émetteur qui présente le second type de conductivité, une région de base active qui fait partie de la couche de base, une tranchée de grille active (9) comprenant un isolant de grille (11) et une électrode de grille active (10) disposés en son sein, et dans lequel la tranchée de grille active est configurée pour s'étendre à partir d'une surface du substrat semi-conducteur au niveau du premier côté dans la couche de dérive le long d'une première direction ; et
une pluralité de tranchées d'isolation (17) fournies dans le substrat, chaque tranchée d'isolation avoisinant au moins une des cellules actives, dans lequel chacune des tranchées d'isolation est remplie d'un matériau diélectrique, dans lequel chacune des cellules actives présente une première longueur L1 le long d'une seconde direction perpendiculaire à la première direction, et chacune de la pluralité de tranchées d'isolation présente une seconde longueur L2 le long de la seconde direction, et les première et seconde longueurs L1 et L2 satisfont la relation de 0,5 ≤ L2/L1 ≤ 2 ;
dans lequel le dispositif semi-conducteur de puissance comprend :
une pluralité de cellules factices (15B), dans lequel chaque cellule factice comprend une région de base factice qui fait partie de la couche de base, et dans lequel chacune de la pluralité de cellules factices présente une première longueur L1 le long de la seconde direction ; et
dans lequel au moins deux de la pluralité de tranchées d'isolation sont positionnées entre des cellules actives voisines le long de la seconde direction, et dans lequel chacune des cellules factices est fournie entre les au moins deux tranchées d'isolation le long de la seconde direction.

2. Dispositif semi-conducteur de puissance selon la revendication 1, dans lequel les première et seconde longueurs L1 et L2 satisfont en outre la relation de L2/L1 ≤ 1,7.

3. Dispositif semi-conducteur de puissance selon la revendication 1 ou 2, dans lequel chacune de la pluralité de cellules actives comprend en outre une première zone d'implantation (13) fournie entre la région de base active et la couche de dérive, dans lequel la première zone d'implantation est du second type de conductivité et présente une concentration de dopage supérieure à la couche de dérive ; et
facultativement dans lequel la tranchée de grille active est configurée pour s'étendre à travers la couche de base et la première zone d'implantation dans la couche de dérive.

4. Dispositif semi-conducteur de puissance selon une quelconque revendication précédente, dans lequel
(i) les tranchées d'isolation sont remplies exclusivement du matériau diélectrique ; et/ou
(ii) les tranchées d'isolation sont configurées pour s'étendre à partir de la surface du substrat semi-conducteur au niveau du premier côté jusque dans la couche de dérive.

5. Dispositif semi-conducteur de puissance selon une quelconque revendication précédente, comprenant en outre une électrode d'émetteur (21) qui est diélectriquement connectée à la région d'émetteur de chacune de la pluralité de cellules actives et une électrode de collecteur (19) qui est diélectriquement connectée à la couche de collecteur.

6. Dispositif semi-conducteur de puissance selon une quelconque revendication précédente, dans lequel chacune de la pluralité de cellules actives comprend en outre une seconde zone d'implantation (25) entre la tranchée de grille active et la couche de dérive, la seconde zone d'implantation présentant le premier type de conductivité ; et
facultativement dans lequel la seconde zone d'implantation est également fournie entre la tranchée d'isolation et la couche de dérive.

7. Dispositif semi-conducteur de puissance selon une quelconque revendication précédente, dans lequel la seconde direction est parallèle à la surface du substrat semi-conducteur.

8. Dispositif semi-conducteur de puissance selon une quelconque revendication précédente, dans lequel chacune de la pluralité de cellules actives est configurée pour fournir au moins un canal de courant pendant un état actif du dispositif semi-conducteur de puissance ; et
facultativement dans lequel chacune de la pluralité de cellules actives comprend en outre une ou plusieurs des régions de base factices, et dans lequel la région de base active et la région de base factice sont fournies au niveau de côtés opposés de la tranchée de grille active, de sorte que l'au moins une des cellules actives fournit un canal de courant unique pendant l'état actif du dispositif semi-conducteur de puissance.

9. Dispositif semi-conducteur de puissance selon une quelconque revendication précédente, dans lequel chaque tranchée de grille active est fournie au milieu de sa cellule active respective de la pluralité de cellules actives le long de la seconde direction.

10. Dispositif semi-conducteur de puissance selon une quelconque revendication précédente, dans lequel chacune de la pluralité de cellules factices comprend en outre une tranchée de grille factice (9B) qui comprend un isolant de grille et une électrode de grille factice (10B) disposés en son sein ; et
facultativement dans lequel la tranchée de grille factice présente la même dimension que la tranchée de grille active.

11. Dispositif semi-conducteur de puissance selon la revendication 3, dans lequel la première zone d'implantation est fournie au sein de chacune de la pluralité de cellules factices entre la région de base factice et la couche de dérive.

12. Dispositif semi-conducteur de puissance selon la revendication 10 lorsqu'elle dépend de la revendication 6, dans lequel la seconde zone d'implantation est fournie au niveau de chacune de la pluralité de cellules factices entre la tranchée de grille factice et la couche de dérive.

13. Dispositif semi-conducteur de puissance selon une quelconque revendication précédente, comprenant en outre une couche tampon (6) présentant le second type de conductivité, dans lequel la couche tampon est fournie entre la couche de dérive et la couche de collecteur, et présente une concentration de dopage supérieure à la couche de dérive.

14. Procédé de fabrication d'un dispositif semi-conducteur (1B), le procédé comprenant :
la fourniture d'un substrat semi-conducteur (2) comprenant :
une couche de base (5) fournie au niveau d'un premier côté du substrat semi-conducteur, dans lequel la couche de base présente un premier type de conductivité ; et
une couche de dérive (4) présentant un second type de conductivité opposé au premier type de conductivité ;
la gravure sélective de la couche de base et de la couche de dérive pour former une tranchée de grille active (9) et une pluralité de tranchées d'isolation (17) au sein du substrat semi-conducteur ;
la formation d'un isolateur de grille (11) au sein de la tranchée de grille active ;
la formation d'une électrode de grille active (10) au sein de la tranchée de grille active ;
le remplissage de chacune des tranchées d'isolation avec un matériau diélectrique ;
la formation sélective d'une région d'émetteur présentant le second type de conductivité au sein de la couche de base au niveau du premier côté du substrat semi-conducteur, dans lequel la région d'émetteur, une partie de la couche de base dans laquelle la région d'émetteur est fournie et la tranchée de grille active avec l'isolant de grille et l'électrode de grille active fournissent collectivement une pluralité de cellules actives (15), et dans lequel chaque tranchée d'isolation avoisine au moins une des cellules actives ; et
la formation d'une couche de collecteur (3) au niveau d'un second côté du substrat semi-conducteur, la couche de collecteur présentant le premier type de conductivité, dans lequel le second côté est opposé au premier côté, et la couche de dérive est agencée entre la couche de collecteur et la couche de base ;
dans lequel :
la tranchée de grille active est configurée pour s'étendre à partir d'une surface du substrat semi-conducteur au niveau du premier côté jusque dans la couche de dérive le long d'une première direction ;
dans lequel chaque cellule active présente une première longueur L1 le long d'une seconde direction perpendiculaire à la première direction, et chaque tranchée d'isolation présente une seconde longueur L2 le long de la seconde direction ; et
les première et seconde longueurs L1 et L2 satisfont la relation de 0,5 ≤ L2/L1 ≤ 2 ;
le procédé comprenant la formation d'une pluralité de cellules factices (15B), chaque cellule factice comprenant une région de base factice qui fait partie de la couche de base, dans lequel chaque cellule factice présente une première longueur L1 le long de la seconde direction ; et
dans lequel au moins deux des tranchées d'isolation sont positionnées entre des cellules actives voisines dans la seconde dimension, et dans lequel chacune des cellules factices est fournie entre les au moins deux tranchées d'isolation le long de la seconde direction.
